# EUROPEAN PATENT APPLICATION

(11) **EP 2 256 802 A1**
(43) Date of publication of application: **01.12.2010**
(21) Application number: 09161159.0
(22) Date of filing: 26.05.2009
(51) Int. Cl.: H01L 23/485, H01L 23/522

(54) **Semiconductor chip and method of manufacturing a semiconductor chip**

(71) Applicant: NXP B.V., 5656 AG Eindhoven (NL)
(72) Inventor: Van Kempen, Jan, 5656 AE Eindhoven (NL)
(74) Representative: Schouten, Marcus Maria

(57) **Abstract**

A semiconductor chip (2) including a semiconductor substrate with a substrate surface and at least one functional element (6A, 6B) defined at the substrate surface or in the semiconductor substrate, further comprising a first plurality of contact elements (12A, 12B) for the provision of external access to the chip, **characterized in that** the first plurality of contact elements is connected to a first pad structure comprising a first conductive layer portion (8) and on top thereof a second, stress distributing, conductive layer portion (10), so as to define at least one conductive path (14A, 14B) extending from the first plurality of contact elements (12A, 12B) to the functional element in a direction substantially normal to the substrate surface.

## Description

### FIELD OF THE INVENTION

The invention relates to a semiconductor chip including a semiconductor substrate with a substrate surface and at least one functional element defined at the substrate surface or in the semiconductor substrate, further comprising a first plurality of contact elements for the provision of external access to the chip.

The invention further relates to a method of manufacturing such a semiconductor chip.

In wirebonded semiconductor chips, conductive wires are used for contacting the semiconductor chip via external terminals. These wires are bonded to bond pads, which occupy a relatively large area on a substrate of the semiconductor chip. The bond pads are often located outside the active area that contains the active circuitry of the semiconductor chip. Placing the bond pads in the active area is known to require additional measures for preventing mechanical damage to the active circuitry. In both situations however, the bond pads must be connected to the active circuitry of the semiconductor chip via thin metal layer structures that extend along the substrate. In addition, bond pads placed outside the active area increase a size of the substrate, which is costly as it decreases the number of semiconductor chips that can be obtained from a single wafer.

It is therefore an object of the invention to provide a semiconductor chip of the kind mentioned in the opening paragraph with an improved electrical connection between active circuitry and a contact element of the semiconductor chip.

This is achieved in the invention **characterized in that** the first plurality of contact elements is connected to a first pad structure comprising a first conductive layer portion and on top thereof a second, stress distributing, conductive layer portion, so as to define at least one conductive path extending from the first plurality of contact elements to the functional element in a direction substantially normal to the substrate surface.

The invention provides a pad structure separate from an interconnect structure, if present at all. More specifically, the conductive path extends substantially normal to the substrate surface. On the contrary, the thin layers within an interconnect structure also include portions extending laterally, adding to the length of their conductive paths. Due to the normal orientation the length of the conductive path in the present invention is small. Moreover the electrical resistance per square is very small, since the width of the conductive path preferably is larger than that of an interconnect within an interconnect structure. Therewith, a more direct access to the active circuitry is achieved. It is observed for completeness that, on a microstructural level, the conductive path may turn out to have an inhomogeneous charge distribution with peaks focussing to the locations of the contact elements. It is moreover observed for clarity that the term 'substantially normal' indicates that the conductive path is essentially free of conductive tracks extending primarily in a lateral direction.

In order to prevent mechanical damage, the contact pad structure including the second, stress distributing, conductive layer portion is provided. This pad structure is preferably provided with an area sufficiently large to connect a plurality of contact elements thereto. In this manner, the stress is released and distributed twofold: first of all, the second conductive layer portion, suitably a relative soft material with a sufficient thickness, acts to damp out large forces that occur in wirebonding especially. Secondly the large surface area of the pad, in comparison to the surface area of one contact element, and the big volume of the second, stress distributing, conductive layer portion, allows stress distribution within the pad structure.

In an embodiment, the conductive path is formed by the second conductive layer portion and the first conductive layer portion, wherein, along the conductive path, an electrical resistance in the first conductive layer portion is substantially smaller, e.g. at least two times smaller or at least ten times smaller, than an electrical resistance in the second conductive layer portion. The first and second conductive layer portion arranged in this way may allow the second conductive layer portion being located close to the functional element such as a doped semiconductor region, with an edge of the second conductive layer portion for example being located within 10 or within 50 micrometer of an edge of the doped semiconductor region. Additionally or alternatively, it may allow substantially omitting from the conductive path a thin metal layer structure that in the prior art forms an electrical connection from the functional element to a bond pad. As a result, an electrical resistance along the conductive path is significantly reduced. Leaving out the bond pad and the thin metal structure towards it, and replacing it by a more direct electrical coupling of the conductive contacting element with the doped semiconductor region, which coupling is preferably directed out of the plane of the active circuitry, is rather surprising, as it goes against a common belief that the conductive path should run towards a bond pad via the thin metal layer structure that extends in a plane of the active circuitry away from the doped semiconductor region.

Preferably, a virtual line can be defined that extends from the functional element in a direction perpendicular to the substrate surface and crosses the first conductive layer portion and/or the second conductive layer portion. Preferably, at least 20%, 50%, 80%, or 100% of a total volume of the first conductive layer portion overlaps with, e.g. is located over, the functional element, such as a semiconductor contact region. Preferably, at least 20%, 50%, 80%, or 100% of a total volume of the funtional element overlaps with, e.g. is located under, the second conductive layer portion.

Suitably, the contact elements are distributed over the pad structure. The exact distribution can be organized according to different principles including the largest mutual distance and a minimum distance between each individual contact element, a minimum distance to an edge of the pad structure, and at least one contact element within a subarea of the pad structure. A suitable number of subareas is for instance 4, 6 or 8. Suitably, also the exact position of underlying elements is taken into account, particularly if the one pad structure is coupled to more than one functional element. In any case, the distribution is suitably a more homogeneous distribution than prior art embodiments wherein a row of contact elements is coupled to one edge of a pad structure.

The conductive path suitably ends up at elements that are in need of a good power supply, an appropriate output channel of a high current and/or high voltage signal, and/or a need for an excellent grounding. Specific appliciations include driver ICs and driver transistors, RF power amplifiers, audio amplifiers and other, general purpose amplifiers, grounding for system ESD protections, or specific RF circuits, and also elements that are driven by a high voltage, such as specific actuators.

On a more specific level, the conductive path may end up at the top electrode of a capacitor, suitably a capacitor coupled to the substrate. Alternatively, it may extend to an electrode of a transistor, or to a buried region in the substrate. The transistor electrode is preferably a doped region in the substrate. Instead of one transistor, it could be a plurality of coupled transistors, or a plurality of transistor segments, particularly of a power transistor, coupled in parallel.

Suitably, the chip further comprises an interconnect structure for mutually interconnecting a plurality of functional elements in the chip, said interconnect structure comprising a plurality of alternatingly electrically conductive and electrically insulating layers and being provided with a second plurality of contact elements for external access. It appears inefficient to use the current 'direct connection pad structures' for any contact of the chip. There is not sufficient space to do so, and moreover, the functionality of an integrated circuit is only achieved by appropriately interconnecting transistors and other functional elements. The use of an interconnect structure in addition to the direction connection pad structures may cause certain lack of planarity. If needed, the conductive path could be extended to comprise several conductive layer pad portions (e.g. metallisation layers). It is observed for clarity that, in view of dimensional restrictions, the conductive path might end at one of the lower metallisation layers. It could then be subdivided into a number of conductive paths with smaller width.

Preferably, the second plurality of contact elements is connected to a plurality of further pad structures on top of the interconnect structure, each further pad structure comprising a first conductive layer portion and a second conductive layer portion, which second conductive layer portion is formed simultaneously with the second conductive layer portions of the first pad structure.

In an embodiment, the second conductive layer portion is applied using electroless deposition. This enables deposition of a relatively thick, for example between 3 and 10 micrometer, typically 5 micrometer, second conductive layer portion. However, the relatively thick second conductive layer portion can also be applied in other ways. The electroless deposition results in a layer that turns out to have appropriate microstructure for acting as a stress release. This is believed due to engineering factors such as the kinetics of growth of the material and its specific microstructure. A flexibitility in design is an additional advantage of the use of electroless deposition. The electroless deposition technique can be used without the need of a planar surface and can be used for the deposition of patterns that are of different surface area. Therewith, it allows the deposition of the second conductive layer portion both for the first pad structure and for any further pad structures that are coupled to any interconnect structure that is favorably present. The first pad structure would have a larger surface area, while the height of the interconnect structure might extend above that of the separate conductive path in the invention.

In an embodiment, the functional element with suitably a doped semiconductor region is provided at a first main side of the semiconductor substrate, wherein a second main side of the semiconductor substrate is substantially covered by a backside metallisation layer portion. Metallisation of the second main side during electrolessly depositing the second conductive layer portion is usually prevented by covering it with an organic layer. In the present embodiment however, metallisation of the second main side during electrolessly depositing the second conductive layer portion is allowed, thus surprisingly forming a layer that enables soldering the semiconductor chip to another element, for example a heat sink with its second main side facing the heat sink. This is especially advantageous if the semiconductor chip is arranged for power applications, wherein a relatively large amount of power is dissipated.

The contact element is preferably formed by a conductive wire, but can also be formed otherwise, for example by a solder bump. Preferably, the contact element establishes external accessibility of the semiconductor chip. Preferably, the contact element forms an electrical connection for externally contacting the semiconductor chip.

In an embodiment, the contact element is formed by the conductive wire that includes copper. Additionally or alternatively, the conductive wire has a diameter that is substantially smaller than 50 micrometer. Preferably, the diameter of the conductive wire is smaller than 40 micrometer, more preferably smaller than 30 micrometer, in particular smaller than 20 micrometer. In the prior art, wires of at least 50 micrometer diameter are necessary to limit electrical resistance, in particular in case the semiconductor chip is arranged for power applications, more in particular in case the conductive wires form conductive output wires. The reduced resistance along the conductive path enables using the conductive wire that has a diameter that is substantially smaller than 50 micrometer. Decreasing the diameter has a cost advantage with respect to commonly used wires. In addition, manufacturing equipment is normally designed for using conductive wires of similar diameter for input and output of the semiconductor chip. This often leads to one or more conductive input wires that are thicker than would be necessary, for example if the input wire is coupled to a gate of a transistor and the output wire is coupled to a source or drain of the transistor. This disadvantage is reduced or prevented in this embodiment.

Using conductive wires that contain copper or an alloy containing copper shows a cost advantage compared to the prior art, wherein gold wires are used. Using copper is especially advantageous in case the second conductive layer portion contains nickel, preferably applied by electroless deposition. Copper and nickel show a good adhesion, and known problems arising from brittle interfaces that form as a result of diffusion of gold into aluminum bond pads can be prevented. This increases mechanical life of the semiconductor chip.

In an embodiment, the first and/or second plurality of contact elements form parallel conductive connections from the first pad structure and/or the further pad structures to a common external terminal. The parallel connections allows an increase in the density of contact elements, particularly wires, and therewith the reduction of the diameter of such conductive wires and/or a reduction in the electrical resistance and/or an increase in the maximum allowable power density.

It is another object of the invention to provide a method of manufacturing a semiconductor chip with an improved electrical connection between active circuitry and a contact element of the semiconductor chip.

According to the invention, the method of manufacturing a semiconductor chip comprising a semiconductor substrate with a substrate surface and at least one functional element defined at the substrate surface or in the semiconductor substrate, comprises the steps of:
- providing a first pad structure comprising a first conductive layer portion and on top thereof a second, stress distributing, conductive layer portion;
- connecting a first plurality of contact elements for the provision of external access to the chip to the first pad structure, so as to define at least one conductive path extending from the first plurality of contact elements to the functional element in a direction substantially normal to the substrate surface.

In one embodiment, this comprises:
a) creating a doped semiconductor region on the semiconductor substrate;
b) applying a first conductive layer portion in proximity of the doped semiconductor region; and
c) applying a second conductive layer portion and a contact element with the second conductive layer portion arranged in between the first conductive layer portion and the contact element, for forming a conductive path that extends from the contact element towards the doped semiconductor region and is formed by the second conductive layer portion and the first conductive layer portion, and for having, along the conductive path, an electrical resistance in the first conductive layer portion that is substantially smaller than an electrical resistance in the second conductive layer portion.

The semiconductor chip made in this way occupies less area on a substrate of the semiconductor chip, as traditional bond pads can be omitted. In addition, the semiconductor chip made in this way has a reduced electrical resistance along the conductive output path. Hence, a geometry of the conductive path obtained in this way is advantageous. Preferably, a layer thickness and electrical conductivity of the first conductive layer portion, and a layer thickness and conductivity of the second conductive layer portion, are arranged for, in combination with the geometry of the conductive path, having an electrical resistance in the first conductive layer portion that is substantially smaller than an electrical resistance in the second conductive layer portion.

In an embodiment, step b) includes applying the first conductive layer portion on the doped semiconductor region, so that after step c) the doped semiconductor region is electrically connected to the contact element via the conductive path.

In an embodiment, step c) includes applying the second conductive layer portion in overlay with the doped semiconductor region, for facilitating electrical current to flow towards the doped semiconductor region.

In an embodiment, step c) includes applying the second conductive layer portion using electroless deposition, preferably electroless nickel deposition. This offers an efficient possibility to achieve overlay of the second conductive layer portion and the first conductive layer portion, in case the electrolessly deposited second conductive layer portion grows on the first conductive portion, preferably containing aluminum. However, overlay is not necessarily achieved when electroless deposition is used in step c).

The invention will now be described, in a non-limiting way, with reference to the accompanying drawings, in which:
Fig. 1 shows a semiconductor chip 2 in a first embodiment according to the invention;
Fig. 2 shows a perspective view of an example of a conductive output wire and an example of a second conductive layer portion;
Fig. 3 shows a transparent top view of a semiconductor chip in a second embodiment according to the invention;
Fig. 4 shows a semiconductor chip in a third embodiment according to the invention; and
Fig. 5 shows a block diagram of an electronic amplifier circuit.

Unless stated otherwise, the same reference numbers refer to like components throughout the drawings.

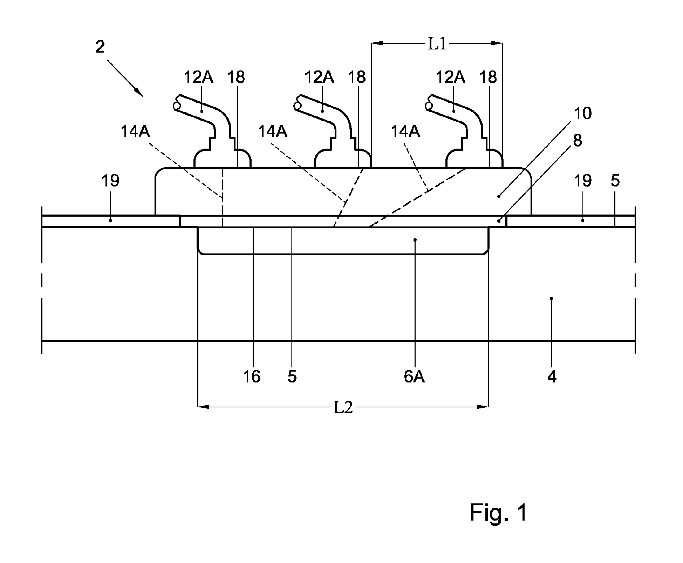

Fig. 1 shows a semiconductor chip 2 in a first embodiment according to the invention. The semiconductor chip 2 includes a semiconductor substrate 4, for example substantially made of silicon. The semiconductor substrate 2 has a substrate surface 5 and at least one functional element defined at the substrate surface 5, The functional element is for example, at least part of, a transistor or a diode. A doped semiconductor region, which can be p-doped or n-doped, is for example part of the transistor or the diode. In this example, the doped semiconductor region is a doped semiconductor contact region 6A, and is an example of the functional element. The semiconductor chip 2 further includes a first conductive layer portion 8 that may be located on the doped semiconductor contact region 6A. The doped semiconductor contact region 6A and the first conductive layer portion 8 are preferably arranged for mutual electrical contact and preferably mutual mechanical contact. The first conductive layer portion 8 for example contains aluminum. A thickness of the first conductive layer portion 8 may be in a range from 0.1 to 2 micrometer, for example 1 micrometer. The first conductive layer portion 8 may be deposited by sputtering or chemical vapour deposition, and may be patterned by photolithograpic techniques and etching. These deposition and patterning techniques as such are known to the skilled person and a further description is deemed superfluous.

The semiconductor chip 2 also includes a second conductive layer portion 10 and a first plurality of contact elements that are conductive, in this example formed by conductive output wires 12A. Via the conductive output wires 12A the semiconductor chip 2 can be externally accessed. The second conductive layer portion 10 is arranged in between the first conductive layer portion 8 and the conductive output wire 12A. The second conductive layer portion 10 is arranged for distributing stress and thus forms a second, stress distributing, conductive layer portion.

In this example, the first and second conductive layer portions form a first pad structure. Thus, the first plurality of contact elements is connected to the first pad structure comprising the first conductive layer portion 8 and on top thereof the second, stress distributing, conductive layer portion 10.

The second conductive layer portion 10 may be applied using electroless deposition, for example electroless deposition of nickel. Electroless deposition of nickel has an advantage in that it can grow on the first conductive layer portion 8, for example in case the first conductive layer portion 8 is made of aluminum. Electrolessly depositing the second conductive layer portion 10 on the first conductive layer portion 8 assures alignment of the second conductive layer portion 10 with the first conductive layer portion 8. The second conductive layer portion 10, in this example made of nickel, may include a thin gold coating, for example having a thickness of several tens of nanometers. The thin gold coating may be arranged to substantially prevent oxidation of nickel, and may be applied by immersion deposition, a deposition technique known as such by the skilled person.

The conductive output wire 12A may be made of copper or an alloy thereof and may have a diameter in a range from 20 micrometer to 38 micrometer, for example 25 micrometer, being substantially smaller than 50 micrometer. Alternatively or additionally, the conductive output wire 12A includes gold. In this embodiment, the semiconductor chip 2 is provided with a plurality of mutually similar conductive output wires 12A. These conductive output wires 12A may be positioned on the second conductive layer portion 10 with a pitch *L₁* compliant to wire bond capability in a range from 60 to 500 micrometer, the pitch *L₁* for example being in the range from 60 to 500 micrometer.

In this example, it may be clear that the second conductive layer portion 10 is located on the first conductive layer portion 8, and that the conductive output wire 12 is located on the second conductive layer portion 10.

At least one conductive path, in this embodiment a number of conductive output paths 14A, that extend from the conductive output wire 12A to the doped semiconductor contact region 6A is defined by the second conductive layer portion 10 and the first conductive layer portion 8, hence by the first pad structure. The at least one conductive path extends from the first plurality of contact elements to the functional element in a direction substantially normal to the substrate surface 5. In this embodiment, the doped semiconductor region 6 is electrically connected to the conductive output wire 12A via the conductive output path 14A. If, more in general, along the conductive path, an electrical resistance in the first conductive layer portion 8 is substantially smaller than an electrical resistance in the second conductive layer portion 10, than the conductive path may be considered to extend from the first plurality of contact elements to the functional element in a direction substantially normal to the substrate surface 5. In general, the conductive path alternatively may be a conductive supply path and the contact element may be formed by a conductive supply wire. Along the supply wire and the conductive supply path, electrical current may be delivered to the semiconductor chip with low resistive losses.

Three different conductive output paths are indicated by dashed lines 14A. In general, the conductive output path 14A may connect a point on an interface 16 of the doped semiconductor contact region 6A and the first conductive layer portion 8, with a point on an interface 18 of the contact element and the second conductive layer portion 10. Alternatively or additionally, the conductive output path in general may run along a line with minimum length, preferably a straight line, between the point on the interface 16 of the doped semiconductor contact region 6A and the first conductive layer portion 8, and the point on the interface 18 of the contact element and the second conductive layer portion 10. Alternatively or additionally, the conductive output path 14A in general may be defined by a physical flow path of charge flowing from the interface 16 of the doped semiconductor contact region 6A and the first conductive layer portion 8, to an interface 18 of the contact element and the second conductive layer portion 10.

In this example, the first conductive layer portion 8 and the second conductive layer portion 10 are arranged for having, along the conductive output path 14A, an electrical resistance in the first conductive layer portion 8 that is substantially smaller than an electrical resistance in the second conductive layer portion 10. In general, such reduced electrical resistance along the conductive output path 14A decreases an impedance during transient and/or steady-state flow of current along the conductive output path 14A. In this example, this is achieved firstly by the first conductive layer portion 8 being thinner, while in use conducting mainly in the thinnest direction, than the second conductive layer portion 10, secondly by the first conductive layer portion 8 being made of a material of higher conductivity than that of the second conductive layer portion 10, and thirdly by the second conductive layer portion 10 being positioned in overlay with the doped semiconductor contact region 6, so that in use conduction in the first conductive layer portion 8 takes place mainly in a thickness direction of the first conductive layer portion 8. However, in general this can be achieved by one or by two of these three measures as well. More in general it is further noted that, as a result of conduction in the first conductive layer portion 8 taking place in use mainly in the thickness direction of the first conductive layer portion 8 according to the third measure, the conductive path extends in a direction substantially normal to the substrate surface 5.

The second conductive layer portion 10 overlaying the doped semiconductor contact region 6A facilitates electrical current to flow through the first conductive layer portion 8, as current can flow predominantly out of a plane of the first conductive layer portion 8. As a result, the conductive path extends in a direction substantially normal to the substrate surface 5. In this case, a length of the conductive output path 14A through the first conductive layer portion 8 is substantially minimised. In Fig. 1, overlay of the second conductive layer portion 10 and the doped semiconductor contact region 6A is established over a distance *L₂*.

The semiconductor chip 2 may further include an isolating layer portion 19 partly covering the semiconductor substrate 4 leaving free the doped semiconductor contact region 6A. The free doped semiconductor contact region 6A may extend over a distance between 5 and 25 micrometer, typically 10 micrometer, in a direction of the isolating layer portion 19. In general, the second conductive layer portion 10 may cover at least part of the isolating layer portion 19. This distributes a mechanical load on active circuitry on which the second conductive layer portion 10 is deposited, thus reducing a maximum value of a local peak load on the active circuitry. It is thus clear that the second conductive layer portion 10 is a second, stress distributing, conductive layer portion 10. In this example, this active circuitry of the semiconductor chip 2 includes the doped semiconductor contact region 6A. The second conductive layer portion 10 covering the isolating layer portion 19 can effectively be achieved by applying the second conductive layer portion using electroless deposition.

The isolating layer portion 19 may be made of silicon nitride or silicon oxide. The isolating layer portion 19 may be applied for example by chemical vapour deposition or wet-chemical deposition such as spin-coating, and patterned by photolithograpic techniques and etching. These deposition and patterning techniques as such are known to the skilled person and a further description is deemed superfluous.

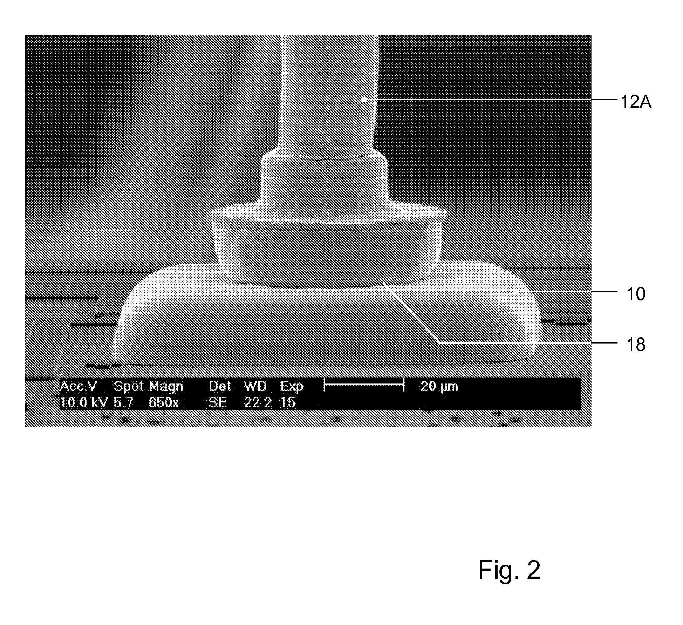

Fig. 2 shows a perspective view of an example of the conductive output wire 12A and an example of the second conductive layer portion 10. The perspective view of Fig. 2 was obtained by using a scanning electron microscope at a magnification of 650 times. In this example, the conductive output wire 12A is attached to the second conductive layer portion 10 by heating the second conductive layer portion 10, preferably combined with exerting a mechanical force on the conductive output wire 12A thus pressing the conductive output wire 12A on the second conductive layer portion 10 (thermocompression bonding). Alternatively or additionally, ultrasonic bonding may be used for attaching the conductive output wire 12A to the second conductive layer portion 10. Thermocompression bonding and ultrasonic bonding are processes known as such to the skilled person.

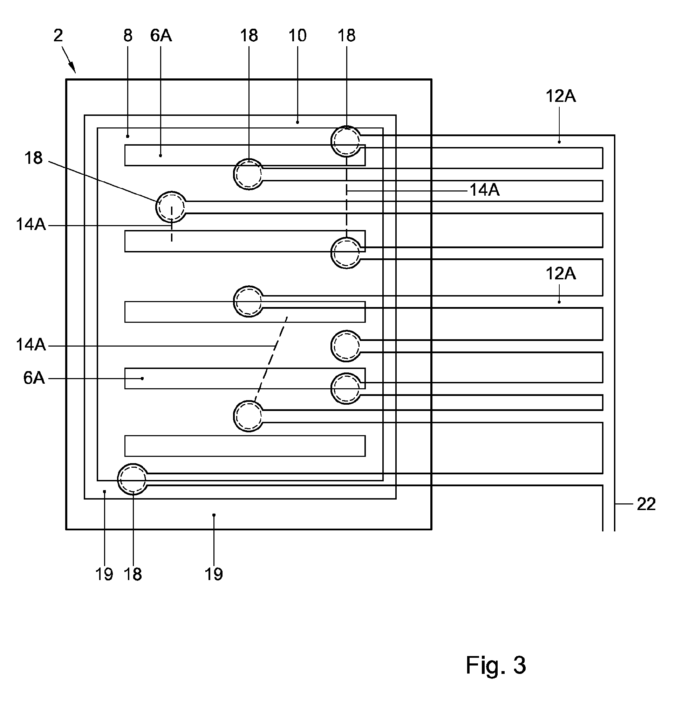

Fig. 3 shows a transparent top view of the semiconductor chip 2 in a second embodiment according to the invention. Fig. 3 shows the first conductive layer portion 8, the second conductive layer portion 10, and the conductive output wires 12A. In this example, the output wires 12A are distributed over the first pad structure that comprises the first conductive layer portion 8 and the second, stress distributing, conductive layer portion 10. Various possible conductive output paths 14A are drawn. These are all considered to extend in a direction substantially normal to the substrate surface.

Fig. 3 further shows a plurality of mutually similar doped semiconductor contact regions 6A. Each one of the plurality of doped semiconductor regions 6A of Fig. 3 may be similar to the doped semiconductor contact region 6A of Fig. 1. A plurality of mutually similar conductive paths 14A extends towards the plurality of doped semiconductor contact regions 6A, and in this embodiment form electrical connections therewith.

The plurality of doped semiconductor contact regions 6A are electrically connected to the second, stress distributing, conductive layer portion 10 via the first conductive layer portion 8. In this embodiment, the plurality of doped semiconductor contact regions 6A are electrically connected to only one second, stress distributing, conductive layer portion 10 via only one first conductive layer portion 8. In another embodiment, the plurality of doped semiconductor contact regions 6A are electrically connected to the second, stress distributing, conductive layer portion 10 via a plurality of mutually similar first conductive layer portions. In this other embodiment, each first conductive layer portion 8 of the plurality of first conductive layer portions 8 may be similar to the first conductive layer portion 8 of Fig. 1.

In the embodiment of Fig. 3, the second, stress distributing, conductive layer portion 10 overlays the plurality of doped semiconductor contact regions 6A. The second, stress distributing, conductive layer portion 10 may as well overlay a significant part of active circuitry of the semiconductor chip 2. In this embodiment the second, stress distributing, conductive layer portion 10 is efficiently placed because it allows the semiconductor substrate 4 of the semiconductor chip 2 to have substantially the same size as is needed for placing the active circuitry.

In the first and second embodiment, the conductive output wires 12A, forming a plurality of mutually similar conductive output wires 12A, may form parallel conductive connections to a common external terminal 22. It may be clear that the conductive output wires 12A are not necessarily all connected to the same external terminal 22.

The semiconductor chip 2 in the second embodiment includes the substrate 4 and may further include the isolating layer portion 19. The isolating layer portion 19 may partly cover the semiconductor substrate 4 and may leave free the plurality of doped semiconductor contact regions 6A. The second conductive layer portion 10 may cover at least part of the isolating layer portion 19.

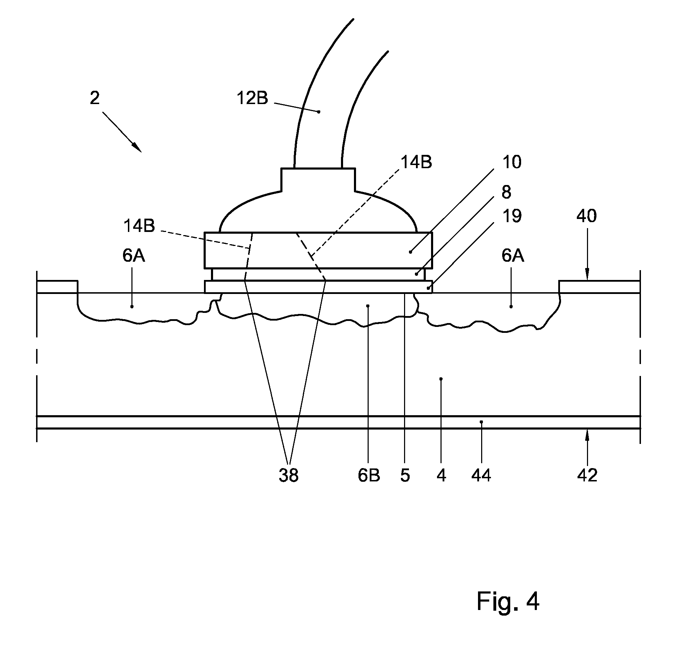

Fig. 4 shows the semiconductor chip 2 in a third embodiment according to the invention. The semiconductor chip 2 includes the first conductive layer portion 8 being located in proximity of the doped semiconductor region, in this example a doped semiconductor channel region 6B. The first conductive layer portion 8 may be located on the isolating layer portion 19 that electrically separates the doped semiconductor channel region 6B from the first conductive layer portion 8. The isolating layer portion 19 may be present between the first conductive layer portion 8 and the doped semiconductor channel region 6B. In the third embodiment, the first conductive layer portion 8 may be a gate of a field-effect transistor. In this example, the isolating layer portion 19 is an example of a functional element defined at the substrate surface 5.

The semiconductor chip 2 further includes the contact element, in this example a conductive input wire 12B. The first conductive layer portion 8 and the second conductive layer portion 10 form the conductive path, in this example a conductive input path 14B from the conductive input wire 12B towards the doped semiconductor channel region 6B. In this example, the conductive input path 14B ends at a position 38 adjacent to the doped semiconductor channel region 6B. The conductive input path 14B runs via the first conductive layer portion 8 and the second conductive layer portion 10 to the conductive input wire 12B. Along the conductive input path 14B, an electrical resistance in the first conductive layer portion 8 is substantially smaller than an electrical resistance in the second conductive layer portion 10. This offers the advantage that an electrical resistance along the conductive input path 14B is significantly reduced, that area of the semiconductor substrate 4 at a first main side 40 is efficiently used as the bond pad and the thin metal structure to the bond pad can be omitted along the conductive path.

Although the conductive input path 14B is similar to the conductive output path 14A, different index letters are used in order to distinguish between input and output. Analogously distinction was made between the conductive input wire 12B and the conductive output wire 12A, and between the doped semiconductor contact region 6A and the doped semiconductor channel region 6B.

In Fig. 4, the second conductive layer portion 10 is located on top of the first conductive layer portion 8 in overlay with the doped semiconductor channel region 6B. However, the second conductive layer portion 10 may be located, partly or completely, outside the doped semiconductor channel region 6B. Part of, or the whole of, the second conductive layer portion 10 may be located near, but not on top of, the first conductive layer portion 10. Although not apparent from Fig. 4, such options for location of the second conductive layer portion 10 may be required in view of a typical length of the doped semiconductor channel region 6B for power applications, being in a range from 1 to 20 micrometer, for example several (between 1.5 and 4) micrometers. This length of the doped semiconductor channel region may be smaller than a diameter of the interface 18. The length of the doped semiconductor channel region 6B alternatively may even be below 1 micrometer.

In general, the doped semiconductor region may be provided at the first main side 40 of the semiconductor substrate 4. A second main side 42 of the semiconductor substrate 4 may be substantially covered by a backside metallisation layer portion 44.

In the third embodiment, the second conductive layer portion 10 overlays the position 38 adjacent to the doped semiconductor channel region. Such an overlay enables electrical current to flow through the first conductive layer portion 8 predominantly in a direction out of a plane of the first conductive metal layer portion 8, thus substantially minimizing electrical resistance through the first conductive metal layer portion 8. This is an example of the conductive path extending in a direction substantially normal to the substrate surface.

The semiconductor chip 2 in the first, second, and/or third embodiment may include the field-effect transistor, wherein a source, a drain or the gate of the transistor is formed by the first conductive layer portion 8. As transistors may occupy a significant part of the semiconductor substrate 4, this measure enables a significant decrease of a size of the semiconductor substrate 4.

In general, the semiconductor chip 2 may further include a plurality of mutually similar and mutually separated second conductive layer portions. The second conductive layer portion 10 may be one of the plurality of mutually similar second conductive layer portions 10, forming together with the plurality of mutually similar first conductive layer portions 8 the plurality of mutually similar conductive paths. These mutually similar conductive paths may be mutually separated. Each one of the conductive paths 14A, 14B may be formed by one of the mutually similar second conductive layer portions 10 and one of the plurality of first conductive layer portions 8. The separated conductive paths 14A, 14B may be related to different transistors, or may be related to one and the same transistor. For example, one conductive path may be the conductive input path 14B of the transistor, and one conductive path may be the conductive output path 14A of the transistor. Alternatively or additionally, more than one of the plurality of conductive paths may be separate conductive output paths 14A of individual transistors.

The source, the drain and/or the gate of the transistor may be connected to the second conductive layer portion of the plurality of second conductive layer portions. In general, the transistor may be arranged for power applications, where a small electrical resistance along the conductive output path 14A and/or the conductive supply path 14A is important.

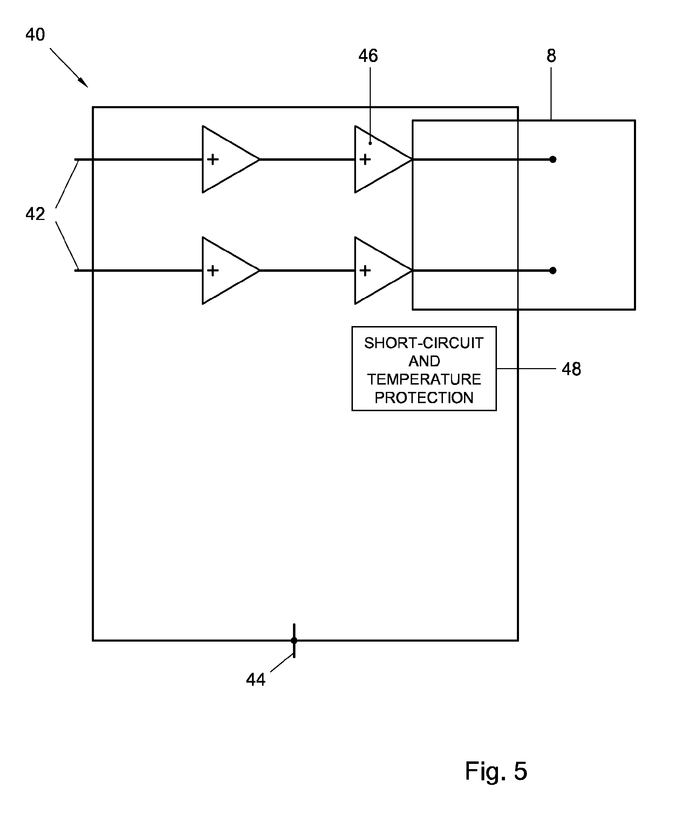

An electronic product may include the semiconductor chip 2. Fig. 5 shows a block diagram 40 of an electronic amplifier circuit, being an example of the electronic product. Alternatively or additionally, the electronic product may be a mobile phone, a radio, a computer, an electronic product for use in automotive applications, an electronic product for power supply management, and/or a sound system. In general, the semiconductor chip may be especially suitable for use in the sound system, because the semiconductor chip 2 may enable a relatively low on-resistance and/or a high output current. This may for example be caused by the electrical resistance in the first conductive layer portion being substantially smaller than the electrical resistance in the second conductive layer portion. The electronic product for use in automotive applications enables exploiting improved thermomechanical properties that the semiconductor chip 2 may have, for example the absence, or at least reduced amount of, contacts between conductive gold wires and aluminum bond pads. Automotive applications require a high reliability as high temperatures can occur, for example under an engine hood of a car or near a dashboard. The contacts between conductive gold wires and aluminum bond pads may degrade relatively quickly under high temperatures.

Fig. 5 shows the first conductive layer portion 8. The electronic amplifier circuit 40 may be provided with input terminals 42, ground terminal 44 and amplifiers 46. The amplifiers 46 may include the transistor. The electronic amplifier circuit may be provided with short-circuit and temperature protection, indicated by a functional block 48.

A method of manufacturing the semiconductor chip including a semiconductor substrate in a first embodiment according to the invention (further referred to as the first method), includes a number of steps. One of these steps is creating a doped semiconductor region on the semiconductor substrate. This step as such is known to the skilled person and a further description is deemed superfluous. Another one of these steps is applying the first conductive layer portion in proximity of and optionally on the doped semiconductor region. This step can for example be carried out by sputtering a metal, such as aluminum, on the doped semiconductor region, followed by patterning using photolithograpic techniques and etching. Such sputtering and patterning techniques as such are known by the skilled person and a further description is deemed superfluous.

A further one of these steps is applying the second conductive layer portion and the contact element. In this way, the conductive output path may be formed from the doped semiconductor region via the first conductive layer portion and the second conductive layer portion to the contact element. The second conductive layer portion may be applied by electroless deposition of nickel followed by immersion deposition of a gold layer. In carrying out the first method, the first conductive layer portion and the second conductive layer portion are arranged for having, along the conductive output path, an electrical resistance in the first conductive layer portion that is substantially smaller than an electrical resistance in the second conductive layer portion. The first method can be used for manufacturing the semiconductor chip 2 in the first, second, and/or third embodiment.

The first method may include applying the second conductive layer portion in overlay with the doped semiconductor region, for facilitating electrical current to flow through the first conductive layer portion.

The semiconductor chip in the first, second, or third embodiment may have a feature that is not disclosed for that embodiment, but is disclosed for another one of the first, second, or third embodiment. The invention is not limited to any embodiment herein described and, within the purview of the skilled person, modifications are possible which may be considered within the scope of the appended claims. Equally all kinematic inversions are considered inherently disclosed and to be within the scope of the present invention. The use of expressions like: "preferably", "in particular", "typically", "especially", etc. is not intended to limit the invention. The indefinite article "a" or "an" does not exclude a plurality. Features which are not specifically or explicitly described or claimed may be additionally included in the structure according to the present invention without deviating from its scope.

## Claims

1. A semiconductor chip including a semiconductor substrate with a substrate surface and at least one functional element defined at the substrate surface or in the semiconductor substrate, further comprising a first plurality of contact elements for external access to and/or from the chip,
**characterized in that** the first plurality of contact elements is connected to a first pad structure comprising a first conductive layer portion and on top thereof a second, stress distributing, conductive layer portion, so as to define at least one conductive path extending from the first plurality of contact elements to the functional element in a direction substantially normal to the substrate surface.

2. The semiconductor chip as claimed in Claim 1, wherein the functional element is a capacitor of which the first conductive layer portion is a top electrode.

3. The semiconductor chip as claimed in Claim 2, wherein the capacitor forms an output capacitor of a driver transistor.

4. The semiconductor chip as claimed in Claim 1, wherein the functional element is a transistor, the conductive path extending to an electrode of the transistor defined as a doped region in the semiconductor substrate.

5. The semiconductor chip as claimed in Claim 1, wherein the functional element is a buried region defined in the semiconductor substrate and the conductive path extends into the substrate.

6. The semiconductor chip as claimed in Claim 4 or 5, wherein a ground connection is provided via the plurality of contact elements and the first pad structure.

7. The semiconductor chip as claimed in Claim 4 or 5, wherein a voltage supply connection is provided via the plurality of contact elements and the first pad structure.

8. The semiconductor chip as claimed in Claim 1, wherein the conductive path is formed by the second conductive layer portion and the first conductive layer portion, wherein, along the conductive path, an electrical resistance in the first conductive layer portion is substantially smaller than an electrical resistance in the second conductive layer portion.

9. The semiconductor chip as claimed in Claim 1, wherein the first plurality of contact elements are distributed over the first pad structure.

10. The semiconductor chip as claimed in Claim 1, further comprising an interconnect structure for mutually interconnecting a plurality of functional elements in the chip, said interconnect structure comprising a plurality of alternatingly electrically conductive and electrically insulating layers and being provided with a second plurality of contact elements for external access.

11. The semiconductor chip as claimed in Claim 10, wherein the second plurality of contact elements is connected to a plurality of further pad structures on top of the interconnect structure, each further pad structure comprising a first conductive layer portion and a second conductive layer portion, which second conductive layer portion is formed simultaneously with the second conductive layer portion of the first pad structure.

12. The semiconductor chip as claimed in Claim 11, wherein the second conductive layer portions are electroless deposited layer portions.

13. The semiconductor device as claimed in Claim 1, wherein the contact elements are wirebonds.

14. A method of manufacturing a semiconductor chip comprising a semiconductor substrate with a substrate surface and at least one functional element defined at the substrate surface or in the semiconductor substrate, comprising the steps of:
- providing a first pad structure comprising a first conductive layer portion and on top thereof a second, stress distributing, conductive layer portion;
- connecting a first plurality of contact elements for the provision of external access to the chip to the first pad structure, so as to define at least one conductive path extending from the first plurality of contact elements to the functional element in a direction substantially normal to the substrate surface.

## Amended claims

### Amended claims in accordance with Rule 137(2) EPC.

**1.** A semiconductor chip including a semiconductor substrate with a substrate surface and at least one functional element defined at the substrate surface or in the semiconductor substrate, further comprising a first plurality of contact elements for external access to and/or from the chip,
wherein the first plurality of contact elements is connected to a first pad structure comprising a first conductive layer portion and on top thereof a second, stress distributing, conductive layer portion, so as to define at least one conductive path extending from the first plurality of contact elements to the functional element in a direction substantially normal to the substrate surface, wherein the contact elements are formed by conductive wires having a diameter substantially smaller than 50 micrometer.

**2.** The semiconductor chip as claimed in Claim 1, wherein the functional element is a capacitor of which the first conductive layer portion is a top electrode.

**3.** The semiconductor chip as claimed in Claim 2, wherein the capacitor forms an output capacitor of a driver transistor.

**4.** The semiconductor chip as claimed in Claim 1, wherein the functional element is a transistor, the conductive path extending to an electrode of the transistor defined as a doped region in the semiconductor substrate.

**5.** The semiconductor chip as claimed in Claim 1, wherein the functional element is a buried region defined in the semiconductor substrate and the conductive path extends into the substrate.

**6.** The semiconductor chip as claimed in Claim 4 or 5, wherein a ground connection is provided via the plurality of contact elements and the first pad structure.

**7.** The semiconductor chip as claimed in Claim 4 or 5, wherein a voltage supply connection is provided via the plurality of contact elements and the first pad structure.

**8.** The semiconductor chip as claimed in Claim 1, wherein the conductive path is formed by the second conductive layer portion and the first conductive layer portion, wherein, along the conductive path, an electrical resistance in the first conductive layer portion is substantially smaller than an electrical resistance in the second conductive layer portion.

**9.** The semiconductor chip as claimed in Claim 1, wherein the first plurality of contact elements are distributed over the first pad structure.

**10.** The semiconductor chip as claimed in Claim 1, further comprising an interconnect structure for mutually interconnecting a plurality of functional elements in the chip, said interconnect structure comprising a plurality of alternatingly electrically conductive and electrically insulating layers and being provided with a second plurality of contact elements for external access.

**11.** The semiconductor chip as claimed in Claim 10, wherein the second plurality of contact elements is connected to a plurality of further pad structures on top of the interconnect structure, each further pad structure comprising a first conductive layer portion and a second conductive layer portion.

**12.** The semiconductor chip as claimed in Claim 11, wherein the second conductive layer portions are electroless deposited layer portions.

**13.** The semiconductor device as claimed in Claim 1, wherein the contact elements are wirebonds.

**14.** A method of manufacturing a semiconductor chip comprising a semiconductor substrate with a substrate surface and at least one functional element defined at the substrate surface or in the semiconductor substrate, comprising the steps of:
- providing a first pad structure comprising a first conductive layer portion and on top thereof a second, stress distributing, conductive layer portion;
- connecting a first plurality of contact elements for the provision of external access to the chip to the first pad structure, so as to define at least one conductive path extending from the first plurality of contact elements to the functional element in a direction substantially normal to the substrate surface,
wherein the contact elements are formed by conductive wires having a diameter substantially smaller than 50 micrometer.
